# EUROPEAN PATENT SPECIFICATION

(11) **EP 2 620 808 B1**
(45) Date of publication and mention of the grant of the patent: **07.03.2018**
(21) Application number: 12778026.0
(22) Date of filing: 15.08.2012
(51) Int. Cl.: G02F 1/1343, G02F 1/1368, G02F 1/1362

(54) **ARRAY SUBSTRATE AND LIQUID CRYSTAL PANEL**
MATRIXSUBSTRAT UND FLÜSSIGKRISTALLANZEIGETAFEL
SUBSTRAT DE MATRICE ET ÉCRAN À CRISTAUX LIQUIDES

(30) Priority: 25.11.2011 CN 201120478218 U
(43) Date of publication of application: 31.07.2013
(73) Proprietor: Beijing BOE Optoelectronics Technology Co., Ltd., Beijing 100176 (CN)
(72) Inventor: WANG, Yongcan, Beijing 100176 (CN); ZHAN, Hongming, Beijing 100176 (CN); LIN, Lifeng, Beijing 100176 (CN); CHEN, Huadang, Beijing 100176 (CN)
(74) Representative: Klunker IP Patentanwälte PartG mbB
(86) International application number: PCT/CN2012/080165
(87) International publication number: WO 2013/075518

(56) References cited:
- WO-A1-2011/024495
- CN-A- 1 245 906
- CN-A- 1 971 364
- CN-A- 102 176 096
- CN-A- 102 243 401
- JP-A- 2009 186 869
- KR-A- 20030 053 562
- US-A1- 2006 061 723

## Description

### TECHNICAL FIELD

Embodiments of the present invention relate to an array substrate and a liquid crystal panel.

### BACKGROUND

Nowadays, liquid crystal displays have been widely used in portable mobile terminals such as mobile phones, personal digital assistants (PDAs) and the like. At present, advanced super dimension switch (ADS) mode liquid crystal panels and the like are especially used to achieve a wide viewing angle effect.

The ADS technology, by forming a multi-dimensional electric field with an electric field generated from edges of slit-electrodes in a same plane and an electric field generated between a slit-electrode layer and a plate-electrode layer, enables liquid crystal molecules in all orientations between the slit-electrodes and directly above the electrodes within a liquid crystal cell to rotate, thereby improving work efficiency of the liquid crystal and increasing light transmission efficiency. The ADS technology can improve image quality of thin film transistor liquid crystal display (TFT-LCD) products, and has advantages of high resolution, high transmittance, low power consumption, wide viewing angle, high aperture ratio, low chromatic aberration, and no push Mura, etc.

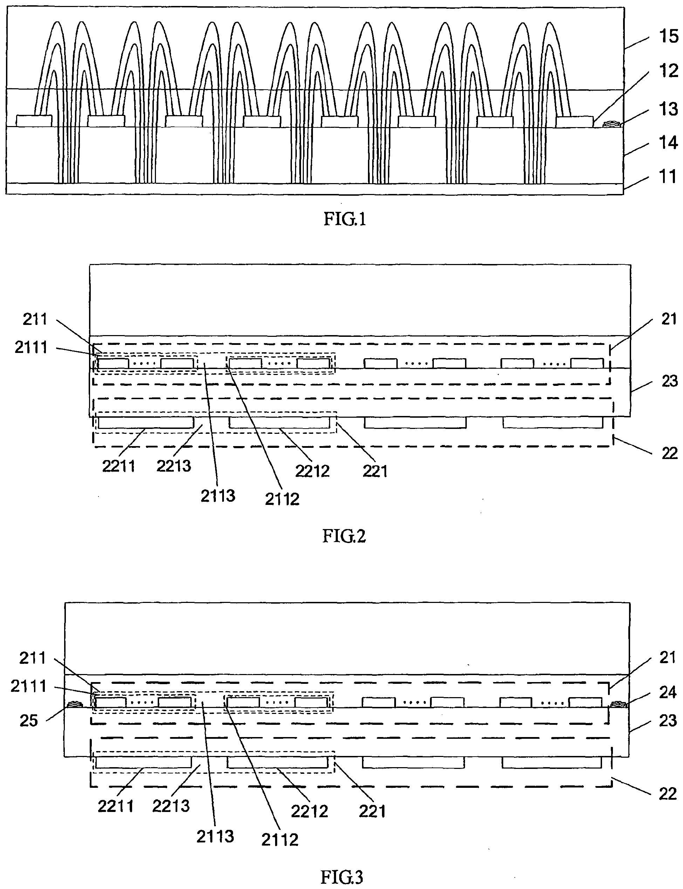

A conventional array substrate comprises a plurality of ADS pixel structures, as shown in FIG. 1. The ADS pixel structure comprises: a common electrode 11, a pixel electrode 12 corresponding to the common electrode 11, and an insulating layer 14 provided between the common electrode 11 and the pixel electrode 12. At one end of each ADS pixel structure, there is connected a thin film transistor (TFT) 13 for controlling the pixel electrode 12. The common electrode 11 is applied with a constant voltage, while the TFT 13 varies the voltage of the pixel electrode 12, thereby varying the voltage difference between the pixel electrode 12 and the common electrode 11 and in turn varying the fringe electric field between the common electrode 11 and the pixel electrode 12. With the fringe electric field being varied, the liquid crystal molecules in the liquid crystal layer 15 located above the array substrate are enabled to rotate, thereby achieving an effect of light transmission control.

CN 102 243 401 A discloses a liquid crystal display device which comprises a first base plate, a second base plate and a liquid crystal layer, wherein the first base plate and the second base plate are arranged oppositely; the liquid crystal layer is sandwiched between the first base plate and the second base plate; the first base plate comprises a transparent substrate, a plurality of scanning lines and a plurality of data lines; the plurality of scanning lines and the plurality of data lines are formed on the transparent substrate; the plurality of scanning lines and the plurality of data lines intersect with each other and define a plurality of pixel areas; each pixel area comprises at least two electrode groups and third transparent electrodes which are arranged between two adjacent electrode groups; each electrode group comprises a first transparent electrode and a second transparent electrode; the first transparent electrodes and the second transparent electrodes are alternately positioned on different layers; when the liquid crystal display device operates, edge electric fields are formed between the first transparent electrodes and the second transparent electrodes in the electrode groups; and horizontal electric fields are formed between the first transparent electrodes and the third transparent electrodes in the electrode groups, so the penetration rate of the whole liquid crystal display device is improved.

KR 2003 0053562 A, considered to be the closest prior art, discloses a fringe field switching LCD device in which liquid crystals are driven by a fringe field and a cross field between a lower electrode and an upper electrode formed of electrodes receiving common signals and signals of thin film transistors respectively. A lower electrode and an upper electrode are opposite to each other for forming an electric field. The lower electrode is formed of a plurality of plate electrodes. One of the plate electrodes is electrically connected with thin film transistor. Another plate electrode is electrically connected with a common bus line. The upper electrode is formed of a plurality of branch electrodes. One of the branch electrodes is electrically connected with the thin film transistor not connected with the plate electrode. Another branch electrode is electrically connected with the common bus line not connected with the plate electrode.

However, the inventors noted that the above-described conventional array substrate has at least the following problems: in the aforementioned ADS pixel structure, the fringe electric field generated by the common electrode and the pixel electrode is distributed non-uniformly, which causes non-uniform light transmission.

### SUMMARY

It is an object of the present invention to provide an array substrate and a liquid crystal panel, for solving the problem - in the existing pixel structure - that the fringe electric field generated by the common electrode and the pixel electrode is non-uniformly distributed, which causes non-uniform light transmission.

The object is achieved by the features of the independent claim. Further embodiments are defined in the dependent claims.

According to the present invention, the first pixel electrode group is composed of at least two sub-electrodes, the second common electrode group is composed of at least two sub-electrode, the first pixel electrode group corresponds to the first common electrode in location and is applied with a second control voltage, and the second common electrode group corresponds to the second pixel electrode in location, i.e. the second common electrode group and the second pixel electrode are aligned in a manner as defined in claim 1, and the pixel structure is configured to apply the second common electrode group with a constant voltage. By applying the second control voltage and applying the constant voltage, the voltage requirements of the whole structure are satisfied.

For example, with the pixel structure, there is disposed a first thin film transistor (TFT) for controlling the applied voltage of the first pixel electrode group. For example, with the pixel structure, there is further disposed a second TFT for controlling the applied voltage of the second pixel electrode. By utilizing the characteristics of the TFTs to control the first pixel electrode group and the second pixel electrode respectively, the voltage requirements of the whole structure are satisfied.

For example, the first control voltage and the second control voltage are equal in absolute values of voltage, opposite in voltage polarity and identical in frequency, and the constant voltage is 0V. In this way, the first control voltage can be obtained by inverting the second control voltage, which not only provides convenience for controlling the voltages, but at the same time, with application of a small voltage, produces a voltage difference between the first pixel electrode and the second pixel electrode, and thereby achieving the effect of a high voltage necessary for the original pixel electrodes.

For example, the first gap and the second gap are aligned in the up-and-down direction, i.e. in the vertical direction. In this way, through the employment of the up-and-down alignment setting, the overlapping area between the second electrode layer and the first electrode layer is reduced, and accordingly the capacitance between the second electrode layer and the first electrode layer is reduced, leading to a bigger speed of varying the first control voltage and a second control voltage, and therefore the panel's response time is improved.

Another embodiment of the present invention provides a liquid crystal panel, comprising: a color filter substrate, an array substrate, and a liquid crystal layer provided between the color filter substrate and the array substrate, and the array substrate comprises a plurality of pixel structures described above.

In the array substrate and the liquid crystal panel provided by embodiments of the present invention, the pixel structure of each pixel unit is as defined in claim 1. Such structure produces a horizontal electric field contained in the fringe electric field generated by the second electrode layer in cooperation with the first electrode layer, so as to make the fringe electric field distributed uniformly, thereby improving transmittance of a liquid crystal panel employing such pixel structure. This solves the problem-in the prior art-that the fringe electric field generated by the common electrode and the pixel electrode is non-uniformly distributed, which causes non-uniform light transmission.

### BRIEF DESCRIPTION OF THE DRAWINGS

In order to clearly illustrate the technical solutions of the embodiments of the invention, the drawings of the embodiments will be briefly described in the following; it is obvious that the described drawings are only related to some embodiments of the invention and thus are not limitative of the invention.
FIG. 1 is a schematic structural view of a pixel structure in the prior art;
FIG. 2 is a first schematic structural view of a pixel structure according to an embodiment of the present invention;
FIG. 3 a second schematic structural view of a pixel structure according to an embodiment of the present invention;
FIG. 4 is a schematic view of a first thin film transistor (TFT) and a second TFT in a pixel structure according to an embodiment of the present invention;
FIG. 5 is a schematic structural view of a pixel structure according to another embodiment of the present invention;
FIG. 6 are the relationship curves between the applied voltage of a pixel electrode and the transmittance, comparing the pixel structure according to another embodiment of the present invention with that of the prior art;
FIG. 7 are the relationship curves between the response time and the transmittance percentage, comparing the pixel structure according to another embodiment of the present invention with that of the prior art; and
FIG. 8 is a schematic structural view of a liquid crystal panel according to further another embodiment of the present invention.

### DETAILED DESCRIPTION

In order to make objects, technical details and advantages of the embodiments of the invention apparent, the technical solution of the embodiments will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

An embodiment of the present invention provides an array substrate for a liquid crystal display. The array substrate comprises a plurality of gate lines and a plurality of data lines, and these gate lines and data lines intersect one other and thereby define a plurality of pixel units that are arranged in a matrix. Each pixel unit comprises a thin film transistor as a switching element. The gate electrode of the thin film transistor of each pixel unit is connected to or integrally formed with the corresponding gate line, and one of the source/drain electrodes of the thin film transistor is connected to or integrally formed with the corresponding data line. Below, the description will be given for the pixel structure of each pixel unit.

The pixel structure provided by the embodiment of the present invention, as shown in FIG. 2, comprises: a first electrode layer 21 and a second electrode layer 22 which overlap with each other, with an insulating layer 23 disposed between the second electrode layer 22 and the first electrode layer 21. A fringe electric field is generated by the second electrode layer 22 in cooperation with the first electrode layer 21.

The second electrode layer 22 comprises a plurality of second electrode groups 221, and furthermore, the second electrode group 221 each comprises a first common electrode 2211 and a second pixel electrode 2212. A first gap 2213 is disposed between the first common electrode 2211 and the second pixel electrode 2212. The first common electrode 2211 is applied with a constant voltage, and the second pixel electrode 2212 is applied with a first control voltage.

The first electrode layer 21 comprises a plurality of first electrode groups 211 corresponding to the second electrode groups 221, and the first electrode group 211 each comprises a first pixel electrode group 2111 and a second common electrode group 2112, with a second gap 2113 disposed between the first pixel electrode group 2111 and the second common electrode group 2112.

As described above, the pixel structure provided by the embodiment of the present invention comprises a second electrode layer and a first electrode layer, wherein the second electrode layer comprises a plurality of second electrode groups, each comprising a first common electrode and a second pixel electrode, the first common electrode is applied with a constant voltage, and the second pixel electrode is applied with a first control voltage; the first electrode layer comprises a plurality of first electrode groups corresponding to the second electrode groups, and the first electrode group each comprises a first pixel electrode group and a second common electrode group. Such structure can produce a horizontal electric field contained in the fringe electric field generated by the second electrode layer in cooperation with the first electrode layer, so as to make the fringe electric field distributed uniformly and accordingly improves transmittance of the liquid crystal panel employing such pixel structure. This solves the problem-in the conventional technology as shown in FIG. 1-that the fringe electric field generated by the common electrode and the pixel electrode is non-uniformly distributed, which causes non-uniform light transmission.

FIG. 3 illustrates another schematic view of this embodiment, further showing the control section.

Specifically, as shown in FIG. 3, the first pixel electrode group 2111 is composed of at least two sub-electrodes "a", and the second common electrode group 2112 is composed of at least two sub-electrodes "b". The first pixel electrode group 2111 corresponds to the first common electrode 2211 and is applied with a second control voltage, and the second common electrode group 2112 corresponds to the second pixel electrode 2212 and is applied with a constant voltage. By applying the second control voltage and applying the constant voltage, the voltage requirements of the whole structure are satisfied.

In one example, as shown in FIG. 3, with the pixel structure, there is disposed a first thin film transistor (TFT) 24 for controlling the applied voltage of the first pixel electrode group 2111; also with the pixel structure, there is further disposed a second TFT 25 for controlling the applied voltage of the second pixel electrode 2212. By utilizing the characteristics of the TFTs to control the first pixel electrode group and the second pixel electrode respectively, the voltage requirements of the whole structure are satisfied.

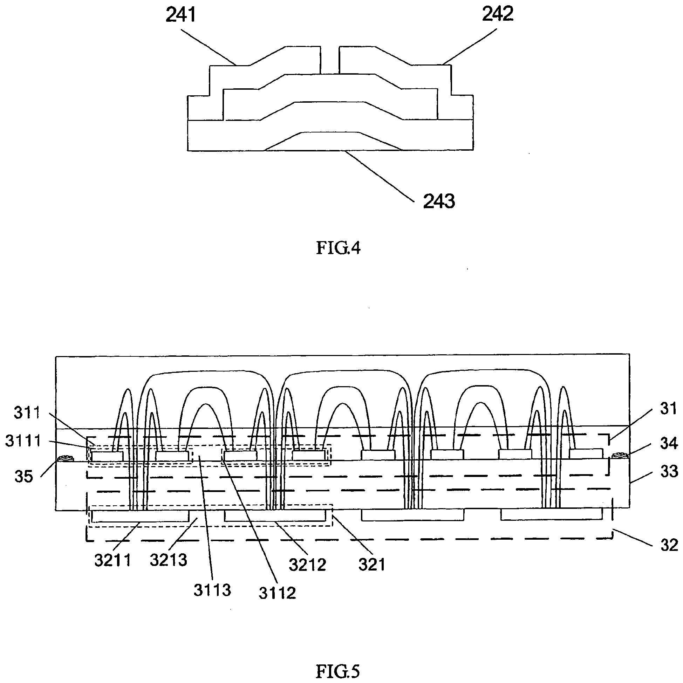

In one example, as shown in FIG. 4, the first thin film transistor (TFT) 24 and the second TFT 25 may be identical to each other in structure, each comprising: a TFT source electrode 241, a TFT drain electrode 242, a TFT gate electrode 243, a gate insulating layer 244, and an active layer 245.

For example, the first control voltage and the second control voltage may be equal in absolute value of voltage, opposite in voltage polarity, and identical in frequency; the constant voltage is, for example, 0V. In this way, the first control voltage can be obtained by inverting the second control voltage; furthermore, it not only provides convenience for controlling the voltages, but at the same time, with application of a small voltage, produces a voltage difference between the first pixel electrode and the second pixel electrode, thereby achieving the effect of a high voltage necessary for the original pixel electrodes.

For example, if the second control voltage is a voltage of +1V, then a voltage of -1V can be obtained only by an inverting process for the voltage value of the second control voltage, and then applied to the second pixel electrode, forming a first control voltage.

For example, the first gap 2213 and the second gap 2113 are aligned in up-and-down direction. In this way, through the employment of the up-and-down alignment, the overlapping area between the second electrode layer and the first electrode layer is reduced, and accordingly the capacitance between the second electrode layer and the first electrode layer is reduced, leading to a bigger speed of varying the first control voltage and the second control voltage, and therefore the panel's response time is improved.

In order to make the technical solution provided by the embodiments of the present invention better understood for the skilled in the art, a pixel structure according to another embodiment of the invention will be described in detail now.

The pixel structure according to another embodiment of the invention, as shown in FIG. 5, comprises a first electrode layer 31 and a second electrode layer 32 which overlap with each other, with an insulating layer 33 provided between the second electrode layer 32 and the first electrode layer 31, and a fringe electric field is generated by the second electrode layer 32 in cooperation with the first electrode layer 31. The curves in FIG. 5 represent the electric fluxlines in the electric field that are generated as a result of the voltage difference applied between the first electrode layer 31 and the second electrode layer 32.

The second electrode layer 32 comprises a plurality of second electrode groups 321, and the second electrode group 321 each comprises a first common electrode 3211 and a second pixel electrode 3212, with a first gap 3213 provided between the first common electrode 3211 and the second pixel electrode 3212. The first common electrode 3211 is applied with a constant voltage, and the second pixel electrode 3212 is applied with a first control voltage.

The first electrode layer 31 comprises a plurality of first electrode groups 311 corresponding to the second electrode groups 321, and the first electrode group 311 each comprises a first pixel electrode group 3111 and a second common electrode group 3112, with a second gap 3113 provided between the first pixel electrode group 3111 and the second common electrode group 3112. The first pixel electrode group 3111 is composed of two sub-electrodes "a", and the second common electrode group 3112 is composed of two sub-electrodes "b". The first pixel electrode group 3111 corresponds to the first common electrode 3211 and is applied with a second control voltage, and the second common electrode group 3112 corresponds to the second pixel electrode 3212 and is applied with a constant voltage.

In this embodiment, with the pixel structure, there is disposed a first thin film transistor (TFT) 34 for controlling the applied voltage of the first pixel electrode group 3111; also with the pixel structure, there is further disposed a second TFT 35 for controlling the applied voltage of the second pixel electrode 3212. By utilizing the characteristics of the TFTs to control the first pixel electrode group and the second pixel electrode respectively, the voltage requirements of the whole structure are satisfied.

In one example, the first control voltage and the second control voltage are, for example, equal in absolute values of voltage, opposite in voltage polarity and identical in frequency; the constant voltage is, for example, 0V. In this way, the first control voltage can be obtained by inverting the second control voltage, which not only provides convenience for controlling the voltages, but at the same time, with application of a small voltage, produces a voltage difference between the first pixel electrode and the second pixel electrode, thereby achieving the effect of a high voltage necessary for the original pixel electrodes.

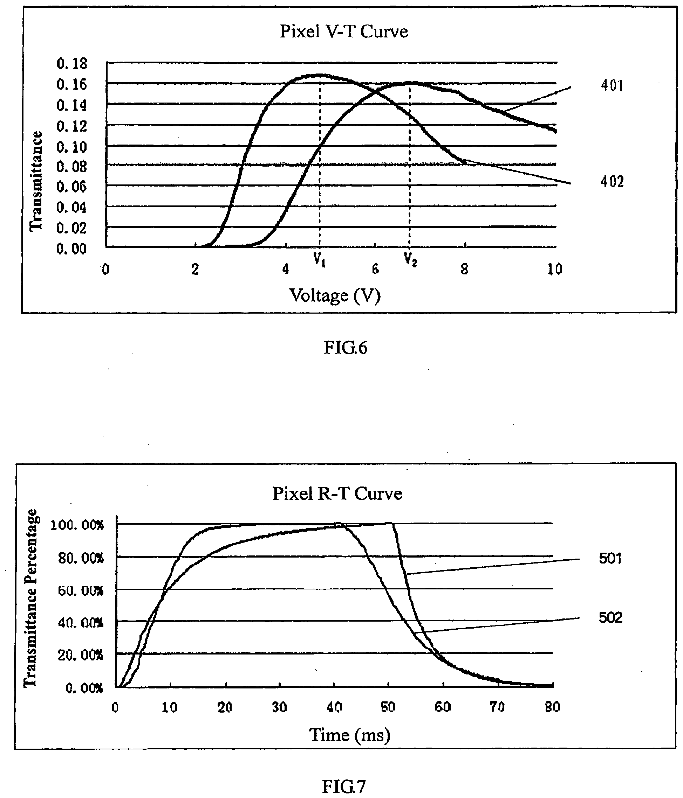

In this embodiment, simulation experiments are conducted for the above-described pixel structure. As shown in FIG. 6, the voltage-transmittance relationship curve 402 of this embodiment is obtained. Compared with the voltage-transmittance relationship curve 401 of the prior art, the pixel structure provided in this embodiment can achieve a transmittance of 0.168, while the transmittance is 0.159 in the prior art; therefore, it can be seen that the transmittance of the modified pixel is improved. Moreover, in the case for reaching the maximum transmittance, the applied voltage of the first electrode layer in this embodiment V1 = 4.8V, is lower than the applied voltage of the pixel electrode in the prior art V2 = 6.8V. Further, the first gap 3213 and the second gap 3113 are aligned in the up-and-down direction. In this way, through the employment of the up-and-down alignment setting, the overlapping area between the second electrode layer and the first electrode layer is reduced, and accordingly the capacitance between the second electrode layer and the first electrode layer is reduced, leading to a bigger speed of varying the first control voltage and a second control voltage, and therefore the panel's response time is improved.

In this embodiment, simulation experiments are conducted for the above-described pixel structure, as shown in FIG. 7, and the response time-transmittance percentage relationship curve 502 of this embodiment is obtained. Compared with the response time-transmittance percentage relationship curve 501 of the prior art, the black-and-white response time curves, respectively obtained from RT response time simulations conducted at the voltages corresponding to the maximum transmittances, are as follows: curve 501, Tᵣ =22.3 ms, T_{f} =11.8 ms, T = Tᵣ + T_{f} =34.1 ms; and curve 502, T'ᵣ = 9.9 ms, T'_{f} =19.1 ms, T' = T'ᵣ + T'_{f} =29 ms. Since T' < T, it can be seen that the response speed in this embodiment is superior to that in the prior art. Tᵣ is the response time required for the transmittance percentage to change from 10% to 90% in the prior art; T_{f} is the response time required for the transmittance percentage to change from 90% to 10% in the prior art; T'ᵣ is the response time required for the transmittance percentage to change from 10% to 90% in this embodiment; and T'_{f} is the response time required for the transmittance percentage to change from 90% to 10% in this embodiment.

This embodiment of the invention provides a pixel structure, the pixel structure comprising a second electrode layer and a first electrode layer, wherein the second electrode layer comprises a plurality of second electrode groups, each comprising a first common electrode and a second pixel electrode, the first common electrode is applied with a constant voltage, and the second pixel electrode is applied with a first control voltage; the first electrode layer comprises a plurality of first electrode groups corresponding to the second electrode groups, the first electrode group each comprise a first pixel electrode group and a second common electrode group, the first pixel electrode group corresponds to the first common electrode and is applied with a second control voltage, and the second common electrode group corresponds to the second pixel electrode and is applied with a constant voltage; moreover, both the first pixel electrode group and the second common electrode group are composed of two sub-electrodes. Such structure produces a horizontal electric field contained in the fringe electric field generated by the second electrode layer in cooperation with the first electrode layer, so as to make the fringe electric field distributed uniformly, thereby improving transmittance of a liquid crystal panel employing such pixel structure. This solves the problem-in the prior art-that the fringe electric field generated by the common electrode and the pixel electrode is non-uniformly distributed, which causes non-uniform light transmission.

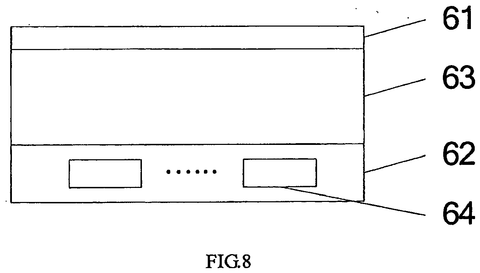

Further another embodiment of the present invention provides a liquid crystal panel, as shown in FIG. 8, comprising: a color filter substrate 61, an array substrate 62, and a liquid crystal layer 63 disposed between the color filter substrate and the array substrate; the array substrate 62 comprises a plurality of pixel structures 64 described above. The pixel structure 64 each is, for example, the same as that in the embodiment shown in FIG. 2, for which the description is omitted here.

This embodiment of the invention provides a liquid crystal panel, and the pixel structure on the array substrate thereof comprises: a second electrode layer and a first electrode layer; the second electrode layer comprises a plurality of second electrode groups, each comprising a first common electrode and a second pixel electrode, the first common electrode is applied with a constant voltage, and the second pixel electrode is applied with a first control voltage; the first electrode layer comprises a plurality of first electrode groups corresponding to the second electrode groups, and the first electrode group each comprises a first pixel electrode group and a second common electrode group. Such structure produces a horizontal electric field contained in the fringe electric field generated by the second electrode layer in cooperation with the first electrode layer, so as to make the fringe electric field distributed uniformly, thereby improving transmittance of a liquid crystal panel employing such pixel structure. This solves the problem-in the prior art-that the fringe electric field generated by the common electrode and the pixel electrode is non-uniformly distributed, which causes non-uniform light transmission.

## Claims

1. An array substrate comprising a plurality of pixel units, with a pixel structure of each pixel unit comprising:
a first electrode layer (21, 31) and a second electrode layer (22, 32) which overlap with each other,
wherein an insulating layer (23, 33) is disposed between the second electrode layer (22, 32) and the first electrode layer (21, 31), and the second electrode layer (22, 32) in cooperation with the first electrode layer (21, 31) are configured to generate a fringe electric field,
the second electrode layer (22, 32) comprises a plurality of second electrode groups (221, 321), each comprising a first common electrode (2211, 3211) and a second pixel electrode (2212, 3212), with a first gap (2213, 3213) disposed between the first common electrode (2211, 3211) and the second pixel electrode (2212, 3212), wherein the array substrate is suitable for applying the first common electrode (2211, 3211) with a constant voltage and the second pixel electrode (2212, 3212) with a first control voltage; and
the first electrode layer (21, 31) comprises a plurality of first electrode groups (211, 311), and each first electrode group (211, 311) comprises a first pixel electrode group (2111, 3111) and a second common electrode group (2112, 3112), with a second gap (2113, 3113) disposed between the first pixel electrode group (2111, 3111) and the second common electrode group (2112, 3112); wherein each first pixel electrode group (2111, 3111) is composed of at least two sub-electrodes, and each second common electrode group (2112, 3112) is composed of at least two sub-electrodes, wherein the array substrate is suitable for applying to each of the first pixel electrode groups (2111, 3111) a second control voltage and to each of the second common electrode groups (2112, 3112) a constant voltage, **characterized in that** the outermost edges of the electrodes of each of the first pixel electrode groups (2111, 3111) and the outermost edges of the first common electrode (2211, 3211) of each of the second electrode groups are aligned in the vertical direction, and the outermost edges of the electrodes of each of the second common electrode groups (2112, 3112) and the outermost edges of the second pixel electrode (2212, 3212) of each of the second electrode groups are aligned in the vertical direction.

2. The array substrate according to claim 1, wherein with each pixel structure, there is disposed a first thin film transistor, TFT (24, 34), for controlling the applied voltage of the first pixel electrode group (2111, 3111).

3. The array substrate according to any one of claims 1-2, wherein with each pixel structure, there is further disposed a second TFT (25, 35) for controlling the applied voltage of the second pixel electrode (2212, 3212).

4. The array substrate according to any one of claims 1-3, wherein the first control voltage and the second control voltage are equal in absolute values of voltage, opposite in voltage polarity and identical in frequency, and the constant voltage is 0V.

5. The array substrate according to any one of claims 1-4, wherein the first gap (2213, 3213) and the second gap (2113, 3113) of each of the second and first electrode groups, respectively, are aligned in the vertical direction.

6. A liquid crystal panel, comprising a color filter substrate (61), an array substrate (62) according to any one of claims 1 to 5, and a liquid crystal layer (63) provided between the color filter substrate (61) and the array substrate (62).

## Patentansprüche

1. Array-Substrat mit einer Vielzahl von Pixeleinheiten, wobei eine Pixelstruktur jeder Pixeleinheit aufweist:
eine erste Elektrodenschicht (21, 31) und eine zweite Elektrodenschicht (22, 32), die einander überlappen,
wobei eine Isolationsschicht (23, 33) zwischen der zweiten Elektrodenschicht (22, 32) und der ersten Elektrodenschicht (21, 31) angeordnet ist, und wobei die zweite Elektrodenschicht (22, 32) zusammenwirkend mit der ersten Elektrodenschicht (21, 31) konfiguriert sind ein elektrisches Randfeld zu erzeugen,
wobei die zweite Elektrodenschicht (22, 32) eine Vielzahl von zweiten Elektrodengruppen (221, 321) aufweist, von denen jede eine erste gemeinsame Elektrode (2211, 3211) und eine zweite Pixelelektrode (2212, 3212) aufweist, wobei ein erster Spalt (2213, 3213) zwischen der ersten gemeinsamen Elektrode (2211, 3211) und der zweiten Pixelelektrode (2212, 3212) angeordnet ist, wobei das Array-Substrat geeignet ist zum Anlegen einer Konstantspannung an die erste gemeinsame Elektrode (2211, 3211) und einer ersten Steuerspannung an die zweite Pixelelektrode (2212, 3212); und
wobei die erste Elektrodenschicht (21, 31) eine Vielzahl erster Elektrodengruppen (211, 311) aufweist, und jede erste Elektrodengruppe (211, 311) eine erste Pixelelektrodengruppe (2111, 3111) und eine zweite gemeinsame Elektrodengruppe (2112, 3112) aufweist, wobei ein zweiter Spalt (2113, 3113) zwischen der ersten Pixelelektrodengruppe (2111, 3111) und der zweiten gemeinsamen Elektrodengruppe (2112, 3112) angeordnet ist; wobei jede erste Pixelelektrodengruppe (2111, 3111) aus wenigstens zwei Unterelektroden gebildet ist, und jede zweite gemeinsame Elektrodengruppe (2112, 3112) aus wenigstens zwei Unterelektroden gebildet ist, wobei das Array-Substrat geeignet ist, zum Anlegen einer zweiten Steuerspannung an jede der ersten Pixelelektrodengruppen (2111, 3111) und einer Konstantspannung an jede der zweiten gemeinsamen Elektrodengruppen (2112, 3112), **dadurch gekennzeichnet, dass**
die äußersten Kanten der Elektroden von jeder der ersten Pixelelektrodengruppen (2111, 3111) und die äußersten Kanten der ersten gemeinsamen Elektrode (2211, 3211) von jeder der zweiten Elektrodengruppen in vertikaler Richtung ausgerichtet sind und die äußersten Kanten der Elektroden von jeder der zweiten gemeinsamen Elektrodengruppen (2112, 3112) und der äußersten Kanten der zweiten Pixelelektrode (2212, 3212) von jeder der zweiten Elektrodengruppen in vertikaler Richtung ausgerichtet sind.

2. Array-Substrat gemäß Anspruch 1, wobei in jeder Pixelstruktur ein erster Dünnschichttransistor, TFT (24, 34) zum Steuern der angelegten Spannung der ersten Pixelelektrodengruppe (2111, 3111) angeordnet ist.

3. Array-Substrat gemäß einem der Ansprüche 1 bis 2, wobei weiter in jeder Pixelstruktur ein zweiter TFT (25, 35) zum Steuern der angelegten Spannung der zweiten Pixelelektrode (2212, 3212) angeordnet ist.

4. Array-Substrat gemäß einem der Ansprüche 1 bis 3, wobei die erste Steuerspannung und die zweite Steuerspannung hinsichtlich der Absolutwerte der Spannung gleich sind, hinsichtlich der Spannungspolarität entgegengesetzt sind und hinsichtlich der Frequenz identisch sind, und die Konstantspannung 0V beträgt.

5. Array-Substrat gemäß einem der Ansprüche 1 bis 4, wobei der erste Spalt (2213, 3213) und der zweite Spalt (2113, 3113) von jeweils jeder der zweiten und ersten Elektrodengruppen in vertikaler Richtung ausgerichtet sind.

6. Flüssigkristall-Panel mit einem Farbfiltersubstrat (61), einem Array-Substrat (62) gemäß einem der Ansprüche 1 bis 5 und einer Flüssigkristallschicht (63), die zwischen dem Farbfiltersubstrat (61) und dem Array-Substrat (62) vorgesehen ist.

## Revendications

1. Substrat matriciel, comprenant une pluralité d'unités de pixel, une structure de pixel de chaque unité de pixel comprenant :
une première couche d'électrode (21, 31) et une seconde couche d'électrode (22, 32) qui se chevauchent entre elles ;
dans lequel une couche isolante (23, 33) est disposée entre la seconde couche d'électrode (22, 32) et la première couche d'électrode (21, 31), et la seconde couche d'électrode (22, 32) coopérant avec la première couche d'électrode (21, 31) est configurée pour générer un courant électrique de frange,
la seconde couche d'électrode (22, 32) comprend une pluralité de seconds groupes d'électrodes (221, 321), chacun comprenant une première électrode commune (2211, 3211), et une seconde électrode de pixel (2212, 3212), avec un premier espace (2213, 3213) disposé entre la première électrode commune (2211, 3211) et la seconde électrode de pixel (2212, 3212), dans lequel le substrat matriciel convient pour appliquer la première électrode commune (2211, 3211) avec une tension constante et la seconde électrode de pixel (2212, 3212) avec une première tension de commande, et
la première couche d'électrode (21, 31) comprend une pluralité de premiers groupes d'électrodes (211, 311), et chaque premier groupe d'électrodes (211, 311) comprend un premier groupe d'électrodes de pixel (2111, 3111) et un second groupe d'électrodes communes (2112, 3112), avec un second espace (2113, 3113) disposé entre le premier groupe d'électrodes de pixel (2111, 3111) et le second groupe d'électrodes communes (2112, 3112) ; dans lequel chaque premier groupe d'électrodes de pixel (2111, 3111) est composé d'au moins deux sous-électrodes, et chaque second groupe d'électrodes communes (2112, 3112) est composé d'au moins deux sous-électrodes ; dans lequel le substrat matriciel convient pour appliquer à chacun des premiers groupes d'électrodes de pixel (2111, 3111) une seconde tension de commande, et à chacun des seconds groupes d'électrodes communes (2112, 3112) une tension constante, **caractérisé en ce que** les bords les plus à l'extérieur des électrodes de chacun des premiers groupes d'électrodes de pixel (2111, 3111) et les bords les plus à l'extérieur de la première électrode commune (2211, 3211) de chacun des seconds groupes d'électrodes sont alignés dans la direction verticale, et les bords les plus à l'extérieur des électrodes de chacun des seconds groupes d'électrodes communes (2112, 3112) et les bords les plus à l'extérieur de la seconde électrode de pixel (2212, 3212) de chacun des seconds groupes d'électrodes sont alignés dans la direction verticale.

2. Substrat matriciel selon la revendication 1, dans lequel avec chaque structure de pixel, on dispose un premier transistor à couches minces, TFT (24, 34), pour commander la tension appliquée du premier groupe d'électrodes de pixel (2111, 3111).

3. Substrat matriciel selon l'une quelconque des revendications 1 à 2, dans lequel avec chaque structure de pixel, on dispose en outre un TFT (25, 35), pour commander la tension appliquée de la seconde électrode de pixel (2112, 3112).

4. Substrat matriciel selon l'une quelconque des revendications 1 à 3, dans lequel la première tension de commande et la seconde tension de commande sont égales en valeurs absolues de tension, de polarité de tension opposée, et de fréquence identique, et la tension constante est 0 V.

5. Substrat matriciel selon l'une quelconque des revendications 1 à 4, dans lequel le premier espace (2213, 3213) et le second espace (2113, 3113) de chacun respectivement des seconds et premiers groupes d'électrodes sont alignés dans la direction verticale.

6. Panneau à cristaux liquides comprenant un substrat de filtre coloré (61), un substrat matriciel (62) selon l'une quelconque des revendications 1 à 5, et une couche de cristaux liquides (63) prévue entre le substrat de filtre coloré (61) et le substrat matriciel (62).
